# EUROPEAN PATENT SPECIFICATION

(11) **EP 2 146 213 B1**
(45) Date of publication and mention of the grant of the patent: **17.08.2011**
(21) Application number: 08172216.7
(22) Date of filing: 18.12.2008
(51) Int. Cl.: G01R 31/317

(54) **Integrated circuit, method and electronic apparatus**
Integrierte Schaltung, Verfahren und elektronisches Gerät
Circuit intégré, procédé et appareil électronique

(30) Priority: 14.07.2008 US 80414 P
(43) Date of publication of application: 20.01.2010
(73) Proprietor: Telefonaktiebolaget L M Ericsson (publ), 164 83 Stockholm (SE)
(72) Inventor: Svensson, Peter, 226 57 Lund (SE); Lostedt, Mikael, 261 62 Glumslöv (SE)
(74) Representative: Åkerman, Mårten Lennart

(56) References cited:
- US-A- 4 698 750
- US-A- 5 293 610
- US-A- 6 076 149
- US-A1- 2003 204 801
- US-A1- 2005 172 185
- US-B1- 7 228 440

## Description

### Technical field

The present invention relates to an integrated circuit having a first security operation state arranged for utility operation and a second security operation state arranged for test operation. The present invention further relates to a method and an electronic apparatus.

### Background

An embedded device, such as an integrated circuit of a communication apparatus, e.g. a mobile phone, will often require the ability to prevent arbitrary software and hardware reconfiguration.

Requirements to protect certain resources can come from standard, e.g. Mobile Trusted Module, 3GPP (3^{rd} Generation Partnership Project), from commercial requirements, e.g. DRM (Digital Rights Management), SIM (Subscriber Identity Module) Yet another requirement field is to implement a reliable theft deterrent, e.g. locking IMEI (International Mobile Equipment Identity) number used to disable stolen handsets. The protection can be against corruption, e.g. unauthorized modification, or against confidentiality leaks, e.g. unauthorized access.

An often-used approach is to have a trusted path through the hardware start-up into the software. The trusted path starts when the chip is reset, and if needed continues through execution of software.

For example, in a mobile phone the IMEI number that is presented to the base station should identify a given device uniquely. The IMEI number is used among other things to bar devices reported as stolen for receiving service. To protect the IMEI the storage of the IMEI and the software that communicates with the base station has to be protected against tampering. A basic requirement is that at least a tampered device must not be usable as a phone.

Another example is keys and identities used to unlock Drum-protected material. These must be protected from being extracted.

During production of an integrated circuit, it is common to run a series of tests at various stages of manufacture. These tests are run to identify individual devices that do not perform as expected. The testing can usually not verify all aspects of an integrated circuit, but a reasonable subset. Some defect chips will slip through this sorting due to errors in parts that are not exercised by the tests.

The production tests need to be fast in order not to slow down the production of the devices and thus increase the cost.

If an error occurs in many devices the yield goes down which increases costs. Even worse are errors that affect many chips but are not caught at the testing. These chips will eventually be assembled into products that may perform poorly or not work at all. The product manufacturer will often return such malfunctioning devices for analysis.

During field return analysis the first objective is to determine the failure cause as precise as possible. The original production tests can be rerun to see if the flaw is a known one that the device has developed since the original production testing of the device.

If the failure cause was not caught by the existing production tests then the second objective is to develop a new test that can detect the flaw during production testing. This newly developed test can then be included in the standard production tests. To verify that the new test actually catches the flaw the production tests are run on the failed device. If the device is flagged as defective the new test is effective.

The requirement to be able to run test at production and to rerun tests on field returns are in conflict with the requirement to prevent access to certain parts of the system. Different methods are available to reconcile these requirements.

A device is often manufactured in a state where security is not yet applied and all included testability mechanisms are enabled. This allows the maximum flexibility in testing which in turn translates to minimal testing times, lower cost and as large test coverage as possible.

At a later stage in production the device is modified to enable security measures. This can be a physical change such as at the packaging stage where important electrical connections are not made available or more subtly by modifying the electrical properties inside device. This can be accomplished by programming fuses/anti-fuses on a chip, writing to persistent memory cells or a plethora of other measures. In this state it is no longer possible to run full tests on the device.

In order to be able to analyze field returns a method is needed to re-enable the test methods. There are several common methods:
· Using a secret mechanism, i.e. "back door". This can be an undocumented pin or and undocumented combination of states on electrical inputs that disable the protection. This decreases security, e.g. by risk of reverse engineering or leaking of the secret of how the back door works.
· Allowing the device to start up to the point where software, whose authenticity has to be verified before it is started, can authenticate and authorize the request to disable all or parts of the security. For example, a boot ROM (Read Only Memory) may receive the request, analyze a cryptographic signature and based on the validity of it enable access to that particular device. The boot ROM in this case can be implicitly authenticated since it is stored on the chip itself.
· Having hardware based, strong authentication of a hardware request. This is similar to the software method described above, but implemented in hardware. The hardware may or may not be shared with the mission mode hardware. For example, a request via JTAG (Joint Test Action Group), i.e. IEEE 1149.1, includes a cryptographic signature that is analyzed by a hardware module to selectively allow access to a particular device.

The latter two requires some authentication mechanism. An approach is presented in WO 2006/004754 A2, where hardware security of a device such as an integrated circuit having secure data stored thereon, is ensured. However, such an approach requires a non-negligible amount of circuitry and logic to authenticate the tester. Further, administration of the authentication makes the testing complex.

US 6,076,149 relates to an approach for memory protection and program security. The approach includes setting bit data of an auxiliary memory before shipment such that a user cannot activate test program. A processing portion of a data processing device then controls writing to the auxiliary memory based on the bit data.

US 4,698,750 relates to an integrated circuit microcomputer with EEPROM. In a first and a second mode for operation, the microcomputer and contents of the EEPROM can be read externally. A security bit can be set to prevent entering the first mode for operation and for erasing the EEPROM when the second mode for operation is entered. The EEPROM is also erased if the security bit is erased.

US 5,293,610 relates to a memory system with security against unauthorised access having a first and a second memory. The memory system prevents access by an external device to the first and second memories during a test mode.

US 7,228,440 relates to a circuit having a logic module and a security module. The security module is configured to disable a scan capability of values set by logic module while in a non-lowest of three security modes, and to enable the scan capability while in the lowest of the three security modes.

US 2003/0204801 relates to a scan controller for protecting sensitive information from electronic hacking. The scan controller denies access to a scan chain until data is cleared from scan-observable portions, and clears scan chain prior to exiting test mode.

US 2005/0172185 relates to an electronic circuit having a test mode and a standard operation mode. A validation circuit produces initialisation signals to command initialisation of configurable cells and then produces a mode-changing signal when it received and instruction for changing mode of operation.

### Summary

The present invention aims to at least alleviate the above stated problem. The present invention is based on the understanding that provision of a separate security operation state having limited operation capabilities enables testing without complex authentication. Instead, the limited operation ensures that no sensitive functions or information is accessed, used, or changed during testing.

According to a first aspect, there is provided a method for an integrated circuit having a first security operation state arranged for utility operation, and a second security operation state arranged for test operation. The method comprises, when operating in the second security operation state, making a first set and a second set of objects available; and making a third set of objects unavailable, and when operating in the first security operation state, making the third set of objects available upon authorization by a security mechanism of the first security operation state. The making of the third set of objects unavailable in the second security operation state is performed by logic circuitry of the integrated circuit. The making of the third set of objects unavailable in the second security operation state comprises controlling limited operation of parts of the integrated circuit comprising the third set of objects when operating in the second security operation state by the logic circuitry.

Here, "utility operation" is operation according to intended purposes of the integrated circuit when for example used in an electronic device, and is to be construed as different from "test operation".

The first and the second security operation states are mutually exclusive, i.e. the integrated circuit is arranged to operate either in the first or the second security operation state, but not in both simultaneously.

The method further comprises making the first set of objects available upon authorization by the security mechanism when operating in the first security operation state. The method further comprises making the second set of objects unavailable by the security mechanism when operating in the first security operation state. The method further comprises deleting confidential and/or sensitive information when entering the second security operation state. The method further comprises deleting states affecting further execution when leaving the second security operation state and returning to the first security operation state to avoid bypassing of the security mechanism of the first security operation state.

The method may further comprise making a fourth set of objects available both when in the first and the second security operation states.

The method may further comprise receiving a test request, and upon reception of the test request, entering the second security operation state. The receiving of the test request may comprise receiving a signal to a test port. The receiving of the test request may comprise detecting a specific electrical state on one or more electrical connectors of the integrated circuit. The specific electrical state may comprise a sequence of in time consecutive sub-states.

According to a second aspect, there is provided an integrated circuit having a first security operation state arranged for utility operation, and a second security operation state arranged for test operation. The integrated circuit is arranged to perform the method according to the first aspect.

Thus, in the second security operation state, a first set and a second set of objects are available, while a third set of objects is unavailable. In the first security operation state, the third set of objects is available with authorization by a security mechanism of the first security operation state. The third set of objects is made unavailable by logic circuitry of the integrated circuit, when operating in the second security operation state. The logic circuitry is arranged to control limited operation of parts of the integrated circuit comprising the third set of objects when operating in the second security operation state.

Here, "utility operation" is operation according to intended purposes of the integrated circuit when for example used in an electronic device, and is to be construed as different from "test operation".

The first and the second security operation states are mutually exclusive, i.e. the integrated circuit is arranged to operate either in the first or the second security operation state, but not in both simultaneously.

The first set of objects are available with authorization by the security mechanism when operating in the first security operation state. The security mechanism of the first security operation state may be arranged to make the second set of objects unavailable when operating in the first security operation state. The integrated circuit further comprises a mechanism arranged to delete confidential and/or sensitive information when entering the second security operation state. Thereby it is possible to avoid extraction of data and keys from the second security operation state.

The integrated circuit further comprises a mechanism arranged to delete objects affecting further execution when leaving the second security operation state and returning to the first security operation state to avoid bypassing of the security mechanism of the first security operation state. Here, object can be register content, internal switch setting, other piece of information, etc. caused during the second security operation state.

A fourth set of objects may be available in both the first and the second security operation states.

The logic circuitry may be arranged to perform the control of limited operation of the second security operation state of parts of the integrated circuit upon detection of a test request. The test request may comprise an input of a signal to a test port. The test request may comprise a specific electrical state on one or more electrical connectors of the integrated circuit. The specific electrical state may comprise a sequence of in time consecutive sub-states.

The parts of the integrated circuit comprising the third set of objects may comprise one or more physically protected circuitry areas in which the third set of objects are implemented. This facilitates disabling of the third set of objects by the logic circuitry. The physically protected circuitry area may further comprise the logic circuitry. This further protects from any security attacks made when in the second security operation state.

The third set of objects may comprise any of Digital Rights Management keys, Subscriber Identity Module functions. International Mobile Equipment Identity storage, radio frequency generation circuitry, security keys, a secured memory area, a clock signal generator, a scan chain generator, or a reset mechanism, or any combination thereof.

According to a third, aspect, there is provided an electronic apparatus comprising an integrated circuit according to the second aspect. The electronic apparatus may be a communication apparatus, for example a cellular telephone.

An advantage of embodiments of the invention is that bypassing of the security mechanism of the first security operation state through operations in the second security operation state is disabled.

### Brief description of drawings

Fig. 1 schematically illustrates security operation states of an integrated circuit according to an embodiment.
Fig. 2 schematically illustrates an integrated circuit according to an embodiment.
Fig. 3 schematically illustrates security operation states of an integrated circuit, together with actions at transitions between states, according to an embodiment.
Fig. 4 is a diagram schematically illustrating availability to sets of objects in security operation states according to an embodiment.

### Detailed description

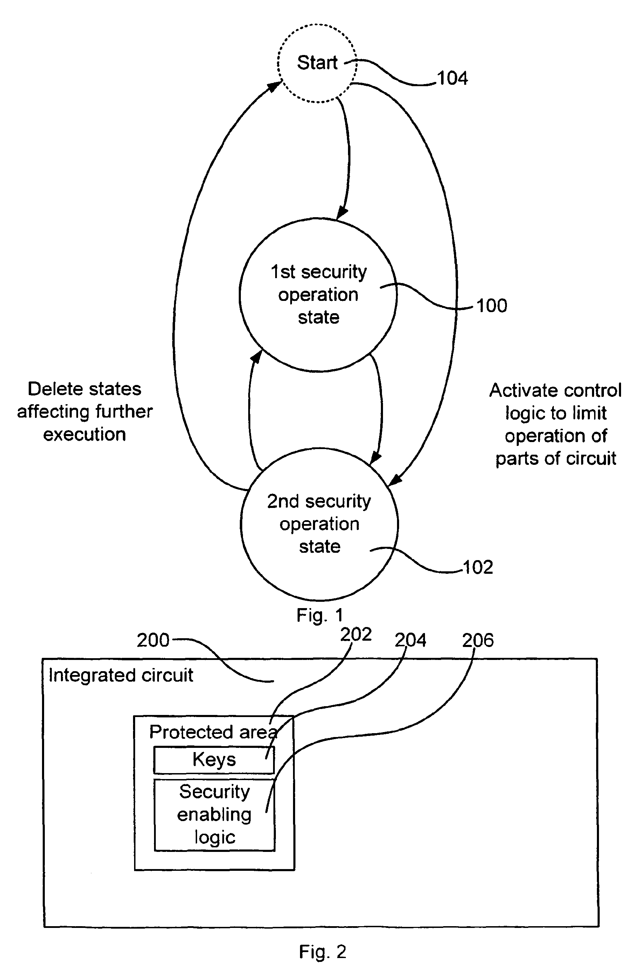

Fig.1: schematically illustrates security operation states of an integrated circuit according to an embodiment. In the illustration, a first security operation state 100 and a second security operation state 102, as well as an optional start state 104, are illustrated. The start state 104 can be a state for improving understanding of how the embodiment works, and is not essential to the function. At start-up of the integrated circuit, or in practice at start-up of the apparatus comprising the integrated circuit, the start state 104 is entered, where it can be determined whether a test interface is being accessed, i.e. if an indication on a test request is present, e.g. a signal is input to a test port. The test interface can be a hardware or a software interface. Hardware interface can be electrical signals connected to one or more pins of the integrated circuit. A specific electrical state can be detected on these pins or connectors to the integrated circuit. Here, the electrical state can be a time-independent electrical state, or a sequence in time of electrical sub-states. The one or more pins can be dedicated test pins, or a suitable set of other available pins at the integrated circuit. Software interface can signals that are decoded by the integrated circuit to determine whether test operations are to be performed. An example on this is requests according to Joint Test Action Group, also known as IEEE 1149.1. If no test operations are determined to be performed, the integrated circuit enters the first security operation state 100, where the start-up and operation is performed according to normal operating procedures and security mechanisms of the first security operation state 100 of the integrated circuit. The first security operation state 100 is arranged for utility operation of the application of an electronic device comprising the integrated circuit, i.e. for the applications which the electronic device product is intended to be used for. If test operations are determined to be performed, the integrated circuit enters the second security operation state 102. The second security operation state 102 is arranged for test operations, e.g. on an electronic device comprising the integrated circuit, i.e. analysis of functions and behaviour of the integrated circuit in its application. Upon entry of the second security operation state 102, control logic is activated to limit operation of certain parts of the integrated circuit, and preferably also to limit some functions controlled by the integrated circuit. Similarly, when operating in the first security operation state and any test operation request is detected as described above, the second security operation state is entered in a similar way.

The limitation of operation is preferably performed as simply as possible to avoid tampering. This can for example be one or more switches in the integrated circuit which are only controlled internally in the integrated circuit, and which disable or disconnect parts or functions that should be protected in the second security operation state 102. Function or parts that can be disabled or disconnected can be certain memory areas, clock signals, control and enabling of for example a radio frequency signal generator such as modulator/demodulator, a communication interface, a scan chain. Here, the control of the scan chain can comprise disabling the ordinary scan chain and replacing it with an alternative scan chain. Another approach is to put at least certain parts of the integrated circuit in a continuous reset state to disable certain functions or access to certain information. Here, access can mean either ability to read information, or to add/change/delete information. For example, in a mobile terminal, an international mobile equipment identity should not be able to be changed. Other examples can be that certain keys should not be readable, such as message authentication code key, digital rights management key, or other encryption or authentication keys, or subscriber identity module functions.

Thus, functions, information, and signals can be considered as objects which are given a structure of availability for the respective security operation states 100, 102. The structure implies that in the second security operation state, a first set and a second set of objects are available, while a third set of objects are unavailable, and in the first security operation state, the third set of objects are available with authorization by a security mechanism of the first security operation state, and the third set of objects is made unavailable by logic circuitry of the integrated circuit, when operating in the second security operation state, by the logic circuitry being arranged to control limited operation of parts of the integrated circuit comprising the third set of objects when operating in the second security operation state. Thus, the third set of objects are made unavailable during test operation, which provides for the limited operation. The first set of objects can be available with authorization by the security mechanism when operating in the first security operation state, while the security mechanism of the first security operation state can be arranged to make the second set of objects unavailable when operating in the first security operation state. This is a part of the security mechanism features for avoiding tampering or unauthorised access of the objects during utility operation of the electronic device. There can also be a fourth set of objects that is available in both the first and the second security operation states 100, 102.

When test operations have been performed and the second security operation state 102 is left, which can be a transition either to the first security operation state to return to utility operation, or to the optional start state 104, e.g. for restart or for turning off. When leaving the second security operation state 102, any object affecting further execution can be deleted to avoid that these objects compromise security mechanisms when entering the first security operation state. Here, object can be register content, internal switch setting, other piece of information, etc. caused during the second security operation state. If no such objects are present or remaining, e.g. depending on the operations performed during the test operations, this is of course not necessary. Deletion of any such objects can be performed as a reset of the integrated circuit.

Fig. 2 schematically illustrates an integrated circuit 200 according to an embodiment. The integrated circuit 200 comprises a protected area 202, i.e. an area that is only controlled internally in the integrated circuit and thus cannot be accessed or manipulated from outside. The protected area, which do not need to be one single area but is to be construed functionally, can comprise sensitive information and functions such as certain memory areas, clock signal control, control and enabling of for example a radio frequency power amplifier or modulator/demodulator, communication interface control, scan chain control, etc. In the protected area 202, information can be stored which should only be accessible via security mechanisms of the first security operation state, as elucidated above. Here, access can mean either ability to read information, or to add/change/delete information. For example, in a mobile terminal, an international mobile equipment identity should not be able to be changed. Other examples are that certain keys 204 should not be readable, such as message authentication code keys, digital rights management keys, or other encryption or authentication keys, or subscriber identity module functions. The protected area is kept concealed by a security enabling logic 206, which can be implemented by logic circuitry that ensures limitation of operation. This is preferably performed as simply as possible to avoid tampering. This can for example be one or more switches in the integrated circuit which are only controlled internally in the integrated circuit, and which disable or disconnect parts or functions that should be protected in the second security operation state. The security enabling logic 206 is activated as soon as a request for test operations is detected, as demonstrated above.

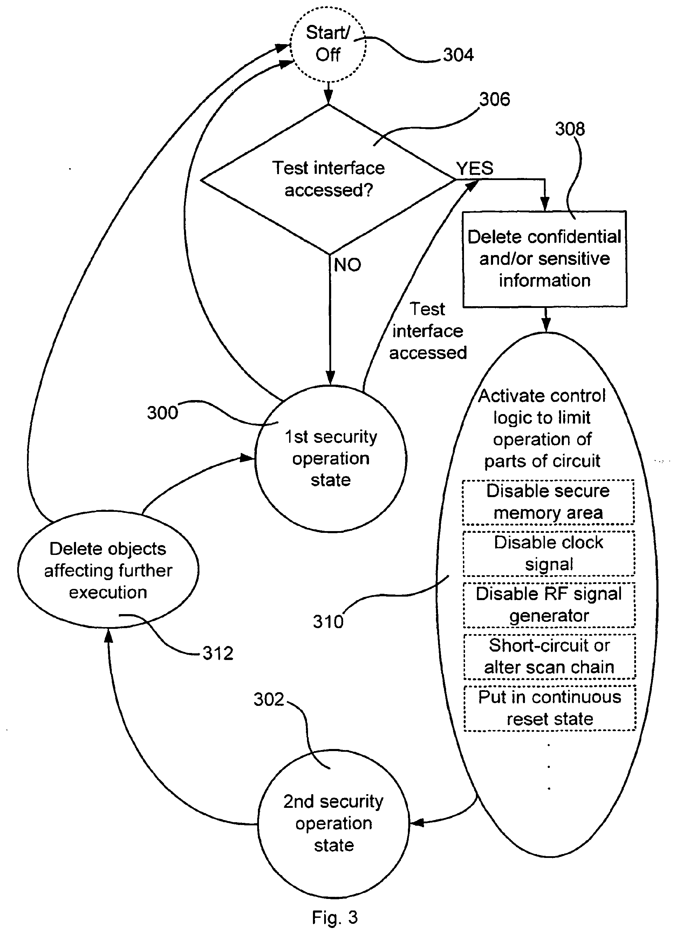

Fig. 3 schematically illustrates security operation states of an integrated circuit, together with actions at transitions between states, according to an embodiment. In the illustration, a first security operation state 300 and a second security operation state 302, as well as an optional start/off state 304, are illustrated. The start/off state 304 can be a state for improving understanding of how the embodiment works, and is not essential to the function. At start-up of the integrated circuit, or in practice at start-up of the apparatus comprising the integrated circuit, the procedure commences at the start/off state 304. In a checking step 306 it is checked whether a test interface is being accessed. As demonstrated with reference to Fig. 1, the test interface can be a hardware or a software interface and have similar features as described above with reference to Fig. 1. If no test operations are determined to be performed, the integrated circuit enters the first security operation state 300, where the start-up and operation is performed according to normal operating procedures and security mechanisms of the first security operation state 300 of the integrated circuit. If test operations are determined to be performed, the integrated circuit enters the second security operation state 302. Upon entry of the second security operation state 302, confidential and/or sensitive information, e.g. user information, certain security keys, profiles, etc., can be deleted in a confidential/sensitive information deletion step 308. Control logic is also activated in a control logic activation step 310 to limit operation of certain parts of the integrated circuit, and preferably also to limit some functions controlled by the integrated circuit. The control logic activation step 310 can comprise one or more sub-steps, e.g. steps for disabling secure memory area, disabling clock signal, disabling radio frequency signal generator, short-circuiting or altering scan chain, putting parts of the integrated circuit in continuous reset state, etc. Similarly, when operating in the first security operation state and any test operation request is detected as described above, the second security operation state is entered in a similar way via the confidential/sensitive deletion step 308 and the control logic activation step 310. The limitation of operation is preferably performed as demonstrated above and with reference to Fig. 1.

When test operations have been performed and the second security operation state 302 is left, any object affecting further execution can be deleted in an object deletion step 312 to avoid that these objects compromise security mechanisms when entering the first security operation state. Here, object can be register content, internal switch setting, other piece of information, etc. caused during the second security operation state. If no such objects are present, e.g. depending on the operations performed during the test operations, this is of course not necessary. Deletion of any such objects can be performed as a reset of the integrated circuit. After that, a transition either to the first security operation state 300 to return to utility operation, or to the start/off state 304, e.g. for restart or for turning off.

The integrated circuit can be utilised in an electronic apparatus. The electronic apparatus can be any apparatus which benefit from test operation and provision of secure operation. The benefit of test operation applies to all electronic apparatuses. The benefit of secure operation can for example apply to cellular phones, media players, digital cameras, personal digital assistants, or common purpose digital computers. In any of these, there can be keys, right management mechanisms, theft protection mechanisms, content, etc. which it is in the interest of the user, a network operator, or the community itself to protect from unauthorised access or tampering.

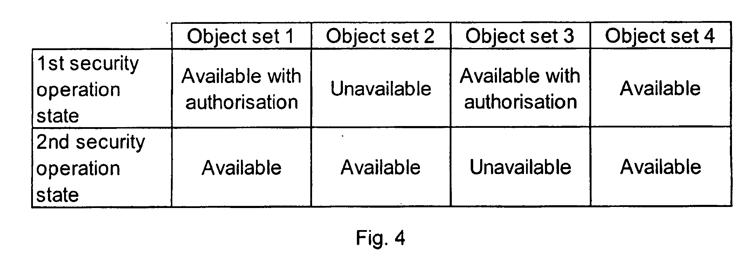

Fig. 4 is a diagram schematically illustrating the availability to sets of objects in the security operation states according to an embodiment. From a security operation state point of view, each security operation state has different criteria on availability to the different sets of objects. The different sets of objects are defined as described above, and the common feature within each set is in this context how it is treated from an availability perspective.

In the first security operation state, as described above, a first set of objects can be available, preferably with authorisation managed by a security mechanism of the first security operation state, while a second set of objects can be unavailable. A third set of objects is available with authorisation, managed by the security mechanism, and there can also be a fourth set of objects that are available without any authorisation. An example of an object of the first set is JTAG-based debug, e.g. authorized by BootRom software after presenting correct credentials in the first security operation state. An example of an object of the second set is register scan chip testing access via JTAG. An example of an object of the third set is enabling of radio, e.g. authorized by the BootRom software after presenting correctly signed code. Examples of objects of the fourth set are anything not involved in security, e.g. timers, universal asynchronous receiver/transmitter, etc.

In the second security operation state, as described above, the first and second sets of objects are available, while the third set of objects is unavailable. There can also be a fourth set of objects that are available. Preferably, in the second security operation state, there is no security mechanism for authorisation. This makes test operation easier since distribution of any access codes, keys, etc. for test operation is not needed. Instead, the structure of a defined set that is unavailable in the second security operation state provides for security. Also, as described above, there can be mechanisms for preventing tampering of security when transitions between the security operation states are made.

From an object point of view, each object can be assigned to any of the categories defined by the object sets. Here, definition of the objects that are unavailable in the second security operation state is the most important improvement. As has been described above, there is provided a particular mechanism for this implemented by logic circuitry.

## Claims

1. A method, for an integrated circuit (200) having a first security operation state (100, 300) arranged for utility operation, and a second security operation state (102, 302) arranged for test operation, the method comprising
when operating in the second security operation state (102, 302),
making a first set and a second set of objects available; and
making a third set of objects unavailable, and
when operating in the first security operation state (100, 300),
making the third set of objects available upon authorization by a security mechanism of the first security operation state (100, 300), wherein
the making of the third set of objects unavailable in the second security operation state (102, 302) is performed by logic circuitry (206) of the integrated circuit (200), and comprising controlling limited operation of parts of the integrated circuit comprising the third set of obj ects when operating in the second security operation state (102, 302) by the logic circuitry (206), wherein the objects are any of functions, information, and signals, the method being **characterised by**
making the second set of objects unavailable by the security mechanism and making the first set of objects available upon authorization by the security mechanism when operating in the first security operation state (100, 300);
deleting (308) confidential or sensitive information when entering the second security operation state (302); and
deleting (312) states affecting further execution when leaving the second security operation state (302) and returning to the first security operation state (300) to avoid bypassing of the security mechanism of the first security operation state (300).

2. The method according to any of claim 1, further comprising making a fourth set of objects available both when in the first and the second security operation states (100, 300; 102, 302).

3. The method according to any of claims 1 or 2, further comprising receiving a test request, and upon reception of the test request, entering the second security operation state (102, 302).

4. The method according to claim 3, wherein the receiving of the test request comprises receiving a signal to a test port, or detecting a specific electrical state an one or more electrical connectors of the integrated circuit (200).

5. An integrated circuit (200) having a first security operation state (100, 300) arranged for utility operation, and a second security operation state (102, 302) arranged for test operation, the integrated circuit (200) being arranged to perform the method according to any of claims 1 to 4.

6. An electronic apparatus comprising an integrated circuit (200) according to claim 5.

7. The electronic apparatus according to claim 6, being a communication apparatus, preferably a cellular telephone.

## Patentansprüche

1. Verfahren für einen integrierten Schaltkreis (200) mit einem ersten Sicherheitsbetriebszustand (100, 300), der für Nutzbetrieb eingerichtet ist, und einem zweiten Sicherheitsbetriebszustand (102, 302), der für Prüfbetrieb eingerichtet ist, wobei das Verfahren umfasst:
beim Betrieb im zweiten Sicherheitsbetriebszustand (102, 302):
Verfügbarmachen einer ersten Menge und einer zweiten Menge von Objekten; und
Nichtverfügbarmachen einer dritten Menge von Objekten, und
beim Betrieb im ersten Sicherheitsbetriebszustand (100, 300):
Verfügbarmachen der dritten Menge von Objekten bei Autorisierung durch einen Sicherheitsmechanismus des ersten Sicherheitsbetriebszustandes (100, 300), wobei
das Nichtverfügbarmachen der dritten Menge von Objekten im zweiten Sicherheitsbetriebszustand (102, 302) durch Logikschaltungen (206) des integrierten Schaltkreises (200) durchgeführt wird und umfasst: durch die Logikschaltungen (206) erfolgendes Steuern des eingeschränkten Betriebs von Teilen der integrierten Schaltung, welche die dritte Menge von Objekten umfassen, beim Betrieb im zweiten Sicherheitsbetriebszustand (102, 302), wobei die Objekte eines von folgendem sind, nämlich Funktionen, Information und Signale, wobei das Verfahren **gekennzeichnet ist durch**:
Nichtverfügbarmachen der zweiten Menge von Objekten **durch** den Sicherheitsmechanismus und Verfügbarmachen der ersten Menge von Objekten bei Autorisierung **durch** den Sicherheitsmechanismus beim Betrieb im ersten Sicherheitsbetriebszustand (100, 300);
Löschen (308) vertraulicher oder heikler Information beim Eintreten in den zweiten Sicherheitsbetriebszustand (302); und
Löschen (312) von Zuständen, welche die weitere Ausführung beeinträchtigen, beim Verlassen des zweiten Sicherheitsbetriebszustandes (302) und Zurückkehren zum ersten Sicherheitsbetriebszustand (300), um ein Umgehen des Sicherheitsmechanismus des ersten Sicherheitsbetriebszustandes (300) zu vermeiden.

2. Verfahren nach Anspruch 1, ferner umfassend: Verfügbarmachen einer vierten Menge von Objekten sowohl im ersten als auch im zweiten Sicherheitsbetriebszustand (100, 300; 102, 302).

3. Verfahren nach Anspruch 1 oder 2, ferner umfassend: Empfangen einer Prüfanforderung und bei Empfang der Prüfanforderung Eintreten in den zweiten Sicherheitsbetriebszustand (102, 302).

4. Verfahren nach Anspruch 3, wobei das Empfangen der Prüfanforderung umfasst: Empfangen eines Signals an einem Prüfanschluss oder Ermitteln eines spezifischen elektrischen Zustandes auf einem oder mehreren elektrischen Verbindern des integrierten Schaltkreises (200).

5. Integrierter Schaltkreis (200) mit einem ersten Sicherheitsbetriebszustand (100, 300), der für Nutzbetrieb eingerichtet ist, und einem zweiten Sicherheitsbetriebszustand (102, 302), der für Prüfbetrieb eingerichtet ist, wobei der integrierte Schaltkreis (200) dafür eingerichtet ist, das Verfahren nach einem der Ansprüche 1 bis 4 durchzuführen.

6. Elektrische Vorrichtung, umfassend einen integrierten Schaltkreis (200) nach Anspruch 5.

7. Elektrische Vorrichtung nach Anspruch 6, wobei es sich um eine Kommunikationsvorrichtung, vorzugsweise ein Mobiltelefon, handelt.

## Revendications

1. Procédé, pour un circuit intégré (200) ayant un premier état de fonctionnement de sécurité (100, 300) agencé pour une opération de service, et un deuxième état de fonctionnement de sécurité (102, 302) agencé pour une opération de test, le procédé consistant à
lors du fonctionnement dans le deuxième état de fonctionnement de sécurité (102, 302),
rendre un premier ensemble et un deuxième ensemble d'objets disponibles ; et
rendre un troisième ensemble d'objets non disponible, et
lors du fonctionnement dans le premier état de fonctionnement de sécurité (100, 300),
rendre le troisième ensemble d'objets disponible sur autorisation d'un mécanisme de sécurité du premier état de fonctionnement de sécurité (100, 300), dans lequel
l'étape consistant à rendre le troisième ensemble d'objets non disponible dans le deuxième état de fonctionnement de sécurité (102, 302) est effectuée par des éléments de circuit logiques (206) du circuit intégré (200), et consistant à commander un fonctionnement limité de parties du circuit intégré comprenant le troisième ensemble d'objets lors du fonctionnement dans le deuxième état de fonctionnement de sécurité (102, 302) par les éléments de circuit logiques (206), dans lequel les objets sont l'un quelconque de fonctions, d'informations et de signaux, le procédé étant **caractérisé par** les étapes consistant à
rendre le deuxième ensemble d'objets non disponible par le mécanisme de sécurité et rendre le premier ensemble d'objets disponible sur autorisation du mécanisme de sécurité lors du fonctionnement dans le premier état de fonctionnement de sécurité (100, 300) ;
supprimer (308) les informations confidentielles ou sensibles lors de l'entrée dans le deuxième état de fonctionnement de sécurité (302) ; et
supprimer (312) les états affectant une exécution ultérieure lors de la sortie du deuxième état de fonctionnement de sécurité (302) et du retour dans le premier état de fonctionnement de sécurité (300) pour éviter le contournemement du mécanisme de sécurité du premier état de fonctionnement de sécurité (300).

2. Procédé selon la revendication 1, consistant en outre à rendre un quatrième ensemble d'objets disponible à la fois dans les premier et deuxième états de fonctionnement de sécurité (100, 300 ; 102, 302).

3. Procédé selon l'une quelconque des revendications 1 et 2, consistant en outre à recevoir une demande de test, et lors de la réception de la demande de test, entrer dans le deuxième état de fonctionnement de sécurité (102, 302).

4. Procédé selon la revendication 3, dans lequel la réception de la demande de test comprend la réception d'un signal sur un port de test, ou la détection d'un état électrique spécifique sur un ou plusieurs connecteurs électriques du circuit intégré (200).

5. Circuit intégré (200) ayant un premier état de fonctionnement de sécurité (100, 300) agencé pour une opération de service, et un deuxième état de fonctionnement de sécurité (102, 302) agencé pour une opération de test, le circuit intégré (200) étant agencé pour effectuer le procédé selon l'une quelconque des revendications 1 à 4.

6. Appareil électronique comprenant un circuit intégré (200) selon la revendication 5.

7. Appareil électronique selon la revendication 6, qui est un appareil de communication, de préférence un téléphone cellulaire.
